# EUROPÄISCHE PATENTSCHRIFT

(11) **EP 2 200 887 B1**
(45) Veröffentlichungstag und Bekanntmachung des Hinweises auf die Patenterteilung: **03.07.2013**
(21) Anmeldenummer: 08785498.0
(22) Anmeldetag: 12.08.2008
(51) Int. Cl.: B62D 29/00, B62D 5/06, B62D 25/10

(54) **VERKLEIDUNGSTEIL FÜR EIN KRAFTFAHRZEUG UND VERFAHREN ZUM HERSTELLEN EINES VERKLEIDUNGSTEILS**
PANEL PART FOR A MOTOR VEHICLE, AND METHOD FOR PRODUCING A PANEL PART
ÉLÉMENT D'HABILLAGE DESTINÉ À UN VÉHICULE À MOTEUR ET PROCÉDÉ DE PRODUCTION D'UN TEL ÉLÉMENT D'HABILLAGE

(30) Priorität: 19.10.2007 DE 102007050125
(43) Veröffentlichungstag der Anmeldung: 30.06.2010
(73) Patentinhaber: Daimler AG, 70327 Stuttgart (DE)
(72) Erfinder: KRÜGER, Jan, 70182 Stuttgart (DE); HUMPENÖDER, Jens, 89077 Ulm (DE); SEILER, Ulrich, 71034 Böblingen (DE)
(74) Vertreter: JENSEN & SON
(86) Internationale Anmeldenummer: PCT/EP2008/006619
(87) Internationale Veröffentlichungsnummer: WO 2009/052884

(56) Entgegenhaltungen:
- EP-A- 1 245 418
- DE-A1- 10 023 546
- DE-A1-102005 050 372
- DE-C1- 10 023 543
- DE-C1- 19 716 389

## Beschreibung

Die Erfindung betrifft ein Verkleidungsteil der Außen- oder Innenverkleidung von Kraftfahrzeugen der im Oberbegriff des Patentanspruchs 1 angegebenen Art. Die Erfindung betrifft weiterhin ein Verfahren zum Herstellen eines Verkleidungsteils der im Oberbegriff des Patentanspruchs 10 angegebenen Art.

Ein derartiges Verkleidungsteil sowie ein derartiges Verfahren sind beispielsweise bereits aus der DE 10 2005 050 372 A1 als bekannt zu entnehmen. Das als Beplankungsteil ausgebildete Außenverkleidungsteil umfasst dabei einen Grundkörper, welcher aus einem lichtdurchlässigen Kunststoff besteht und dessen Außenseite durch eine transparente Deckschicht überdeckt ist. Der Grundkörper umfasst weiterhin eingeklebte oder eingegossene Metallverstärkungen sowie ein Solarmodul und trägt auf seiner Innenseite eine gefärbte Innenlackfolie, durch welche der Grundkörper eine wahrnehmbare Farbe erhält.

Aufgabe der vorliegenden Erfindung ist es, ein Verkleidungsteil der eingangs genannten Art bereitzustellen, welches verbesserte optische Eigenschaften aufweist.

Die Aufgabe wird erfindungsgemäß durch ein Verkleidungsteil mit den Merkmalen des Patentanspruchs 1 sowie durch ein Verfahren zum Herstellen eines Verkleidungsteils mit den Merkmalen des Patentanspruchs 9 gelöst. Vorteilhafte Ausgestaltungen mit zweckmäßigen und nicht-trivialen Weiterbildungen der Erfindung sind in den jeweiligen Unteransprüchen angegeben, wobei vorteilhafte Ausgestaltungen des Verkleidungsteils - soweit anwendbar - als vorteilhafte Ausgestaltungen des Verfahrens und umgekehrt anzusehen sind.

Ein erfindungsgemäßes Verkleidungsteil ist so aufgebaut, dass der Kunststoff das Solarmodul (16) zumindest auf der sonnenzugewandten Seite oder Außenseite des Verkleidungsteils vollständig formschlüssig umgibt. Dabei ist das Solarmodul formschlüssig mit dem Kunststoff verbunden, wie es beispielsweise durch das Eingießen des Solarmoduls in Kunststoff erhältlich ist. Das Solarmodul ist hierdurch über seine gesamte flächige Ausdehnung kraftschlüssig in den Grundkörper integriert.

Der Vorteil dieser Anordnung ist die Integrale Bauweise des Verkleidungsteils mit Solarmodul, bei der auf spezielle Befestigungsvorrichtungen für das Solarmodul versichtet werden kann. Hierdurch lassen sich insbesondere großflächige Solarmodule in einfacher Weise an die Verkleidungsteile binden und als fertiges Modul im Kraftfahrzeug verbauen. Typischerweise sind die Solarmodule durch ein Array aus mehreren Solarzellen, oder auch als Dünnschichtsolarzelle, beispielsweise als amorphe Solarzelle auf einer Trägerfolie aufgebaut.

Durch die großflächige form- und kraftschlüssige Verbindung des Solarmoduls mit dem Grundkörper ist es darüber hinaus möglich, die Unterseite des Solarmoduls im wesentlichen frei, das heißt nicht vom Kunststoff eingegossen auszugestalten. Dies bietet Vorteile für eine gegebenenfalls erforderliche Wartung oder die Anbringung von Medienanschlüssen.

Ein Verkleidungsteil, welches verbesserte optische Eigenschaften aufweist, ist nach weiterer Ausgestaltung der Erfindung dadurch geschaffen, dass das Verkleidungsteil an der Oberseite eine Deckschicht aufweist. Die Oberseite ist die sonnenzugewandte Seite oder auch die Außenseite des Verkleidungsteils. Die Deckschicht weist zumindest im Anordnungsbereich des Solarmoduls eine diesem zugeordnete Aussparung auf. Eine derartige Aussparung ermöglicht dabei einen verbesserten Lichteintritt in den zumindest an dieser Stelle transparenten Kunststoff des Grundkörpers, wodurch der Wirkungsgrad des Solarmoduls aufgrund der verringerten optischen Streu- und Absorptionsverluste vorteilhaft gesteigert wird.

Aufgrund des vergleichsweise geringen Gewichts des Verkleidungsteils im Gegensatz zu Blech- oder Glasverkleidungsteilen kann zudem der Energiebedarf des zugeordneten Kraftfahrzeugs vorteilhaft gesenkt werden. Das Solarmodul kann dabei eine oder mehrere Solarzellen umfassen, welche vorteilhaft miteinander verbunden sein können. Ebenso kann vorgesehen sein, dass die Deckschicht mehrere Aussparungen umfasst, wenn das Solarmodul mehrere, gegebenenfalls voneinander beabstandet angeordnete Solarzellen umfasst. Das Verkleidungsteil bzw. der Grundkörper können dabei in Abhängigkeit des jeweiligen Einsatzzwecks sowohl eben als auch gewölbt ausgebildet sein. Für derartige Geometrien bietet das Eingießen des Solarmoduls in Kunststoff erhebliche Vorteile, denn gerade die exakte Anpassung der dünnen und spröden Solarzellen an die Kontur eines gewölbten Substrates ist andernfalls nur aufwändig zu bewerkstelligen .

In einer vorteilhaften Ausgestaltung der Erfindung ist vorgesehen, dass die Deckschicht als Lackschicht und/oder als Außenlackfolie und/oder als Glasschicht ausgebildet ist. Dies ermöglicht eine variable Ausgestaltung des Verkleidungsteils sowie einen zuverlässigen Schutz des Grundkörpers vor schädlichen Umwelteinflüssen und stellt somit dauerhaft eine hochwertige optische Anmutung des Verkleidungsteils sicher.

Diese Ausführung wird insbesondere für Klappen und Dächer von Fahrzeugen gewählt.

Soll das Verkleidungsteil im Inneren des Fahrzeugs als Teil der Innenverkleidung eingesetzt werden, so kann die Deckschicht auch durch eine Kunststoffschicht gebildet werden. Derartige Kunststoffschichten sind beispielsweise von Armaturenträgern in Personenkraftwagen bekannt. Neben der optischen Wirkung haben diese auch die Aufgabe die Haptik der Oberfläche einzustellen.

In einer weiteren vorteilhaften Ausgestaltung der Erfindung ist vorgesehen, dass die Deckschicht des Verkleidungsteils im wesentlichen lichtundurchlässig und/oder gefärbt ist. Dies ermöglicht im Gegensatz zum Stand der Technik eine optisch vorteilhafte Integration des Verkleidungsteils in die Außenverkleidung einer Karosserie des Kraftfahrzeugs, wodurch ein optisch schlüssiges Gesamterscheinungsbild des Kraftfahrzeugs ermöglicht ist. Die Deckschicht kann dazu beispielsweise dieselbe Farbe aufweisen wie die restlichen Karosseriebauteile oder in Abhängigkeit der jeweiligen Ausgestaltung des Verkleidungsteils eine an die optische Umgebung angepasste Farbe oder einen Farbverlauf besitzen. Alternativ oder zusätzlich kann durch eine undurchsichtige, trübe oder milchige Gestaltung der Deckschicht ebenfalls eine optische Verbesserung des Verkleidungsteils erzielt werden.

Weitere Vorteile ergeben sich, indem die Aussparung durch eine weitere Deckschicht, insbesondere eine UV-Schutzschicht und/oder eine Kratzschutzschicht und/oder eine Decklackschicht und/oder eine transparente Folie, abgedeckt ist. Dies ermöglicht aufgrund des verbesserten Schutzes gegenüber unerwünschten Umwelteinflüssen eine weitere Verbesserung der optischen Langzeiteigenschaften sowohl hinsichtlich des Erscheinungsbildes als auch hinsichtlich des Wirkungsgrads des Solarmoduls.

Eine UV-Schutzbeschichtung ist insbesondere im Zusammenhang mit Polycarbonatgläsern als Kunststoff von Vorteil. Wird Plexiglas (PMMA) als Kunststoff verwendet, werden vorteilhafterweise Kratzfestbeschichtungen angewendet.

Eine Verbesserung der mechanischen Eigenschaften des Verkleidungsteils wird dadurch erzielt, dass der Grundkörper zusätzlich wenigstens ein Versteifungselement, insbesondere einen Strukturträger und/oder eine Faserverstärkung umfasst. Dies erlaubt die Ausbildung von Verkleidungsteilen mit großen Grundflächen, so dass das Verkleidungsteil beispielsweise als Dach eines Kraftfahrzeugs eingesetzt werden kann. Die Strukturträger ragen bevorzugt in geeigneter Weise zur Befestigung an der Karosserie über den Kunststoff des Grundkörpers hinaus. Dabei ist insbesondere eine optisch vorteilhafte Anmutung des Verkleidungsteils dadurch erzielbar, dass das Versteifungselement unterhalb der lichtundurchlässig bzw. gefärbt ausgebildeten Deckschicht angeordnet und somit von außen nicht erkennbar ist.

In einer weiteren vorteilhaften Ausgestaltung der Erfindung ist vorgesehen, dass das Verkleidungsteil als selbsttragendes Verkleidungsteil und/oder als Beplankungsteil und/oder als Dach und/oder als Schiebedach und/oder als Frontklappe und/oder als Heckklappe ausgebildet ist. Dies ermöglicht einen besonders flexiblen Einsatz des Verkleidungsteils in Abhängigkeit der jeweiligen Ausgestaltung des Kraftfahrzeugs.

Eine weitere Ausführung des Verkleidungsteils wird durch Armaturenbrett oder Hutablage in Kraftfahrzeugen gebildet.

Dabei hat es sich weiterhin als vorteilhaft gezeigt, dass das Solarmodul des Verkleidungsteils mit einem Energiespeicherelement, insbesondere einer Batterie eines Elektroantriebs, eines Kraftfahrzeugs koppelbar ist und ausgelegt ist, das Energiespeicherelement mit elektrischer Energie zu versorgen. Auf diese Weise können die durch das erfindungsgemäße Verkleidungsteil erzielbaren Vorteile hinsichtlich erhöhtem Wirkungsgrad des Solarmoduls bei optisch vorteilhafter Anmutung und geringem Gewicht in optimaler Weise zum Einsparen von Energie verwendet werden. Ist das Kraftfahrzeug als Hybridfahrzeug oder Elektrofahrzeug ausgebildet, kann das erfindungsgemäße Verkleidungsteil somit zumindest einen Teil der benötigten Antriebsenergie bereitstellen.

Ein weiterer Aspekt der Erfindung betrifft ein Verfahren zum Herstellen eines Verkleidungsteils für ein Kraftfahrzeug, bei welchem wenigstens ein Solarmodul mit einem zumindest teilweise aus einem lichtdurchlässigen Kunststoff bestehenden Grundkörper des Verkleidungsteils durch Eingießen in den Kunststoff verbunden wird. Als Gießverfahren sind Spritzguss und/oder eines Spritzprägen und/oder Eingießen geeignet. Das Solarmodul wird so angeordnet, dass maximal dessen Unterseite nicht mit eingegossen wird. Dies kann zum Beispiel dadurch erfolgen, dass das Solarmodul mit seiner Unterseite auf eine der Gießformseiten bzw. Gießformhälften aufgebracht wird.

In einer vorteilhaften Ausgestaltung wird beim Eingießen des Solarmoduls gleichzeitig auch eine Deckschicht angegossen. Eine verbesserte optische Eigenschaft des Verkleidungsteils wird dadurch geschaffen, dass eine dem zumindest einen Solarmodul zugeordnete Aussparung in die Deckschicht eingebracht wird. Dies bewirkt einen verbesserten Lichteintritt in den zumindest an dieser Stelle transparenten Kunststoff des Grundkörpers, wodurch der Wirkungsgrad des Solarmoduls aufgrund der verringerten optischen Streu- und Absorptionsverluste vorteilhaft gesteigert wird. Weitere sich ergebende Vorteile sind bereits aus den vorhergehenden Beschreibungen zu entnehmen. Die Deckschicht kann beispielsweise in die obere Gießformhälfte einer zweihälftigen Gießform eingelegt und das Solarmodul auf die untere Gießformhälfte abgelegt werden.

Eine weitere Ausgestaltung sieht den im Wesentlichen vollstädigen Einguss des Solarmoduls vor. Dabei hat es sich als vorteilhaft gezeigt, dass zum Verbinden des wenigstens einen Solarmoduls mit dem Grundkörper das wenigstens eine Solarmodul gegebenenfalls mittels eines Abstandhalters innerhalb einer Formhälfte einer Formvorrichtung angeordnet und der Grundkörper mittels eines Spritzgussverfahrens und/oder eines Spritzprägeverfahrens und/oder eines Gießverfahrens aus dem Kunststoff hergestellt wird. Mit Hilfe eines Spritzgussverfahrens kann das ein Massenteil darstellende Verkleidungsteil besonders wirtschaftlich auch in großer Stückzahl hergestellt werden. Unter Verwendung eines Spritzprägeverfahrens kann der Grundkörper zudem hochgenau hergestellt werden, wodurch optisch vorteilhafte, geringe Spaltmaße erzielt werden. Zudem lassen sich auch großdimensionierte Verkleidungsteile - wie beispielsweise Dachteile - problemlos und mit hoher Genauigkeit herstellen. Dabei kann die Geometrie des Grundkörpers nahezu frei gewählt werden, so dass dieser bzw. das Verkleidungsteil sowohl eben als auch gewölbt hergestellt werden kann. Die gleichen Vorteile können auch durch die Verwendung eines Gießverfahrens erzielt werden, welches sich ebenfalls vorteilhaft für die Massenproduktion sowohl einfacher als auch komplizierter Geometrien eignet. Das Solarmodul kann dabei wahlweise auf der Formhälfte aufliegen und somit nur teilweise in den Kunststoff eingegossen werden. Alternativ kann das Solarmodul mittels eines Abstandhalters beabstandet zur Formhälfte angeordnet und somit von allen Seiten in den Kunststoff eingebettet werden. Die Formhälfte kann dabei in Abhängigkeit der gewünschten Geometrie des Grundkörpers eben oder gewölbt ausgebildet sein. Dabei kann ebenfalls vorgesehen sein, dass ein etwaiges Versteifungselement ebenfalls in der Formhälfte angeordnet und mit eingegossen wird. Umgekehrt kann auch ein entsprechender Hohlraum vorgesehen werden, in welchem das Versteifungselement nachträglich angeordnet und gegebenenfalls durch Kleben festgelegt wird.

Dabei hat es sich weiterhin als vorteilhaft gezeigt, dass zum Verbinden des Grundkörpers mit der Deckschicht zunächst die an eine Außenoberfläche des Verkleidungsteils angepasste Deckschicht, in welche die dem zumindest einen Solarmodul zugeordnete Aussparung eingebracht wird, in einer an eine Außenkontur des Verkleidungsteils angepassten weiteren Formhälfte der Formvorrichtung angeordnet und durch das Spritzgussverfahren und/oder Spritzprägeverfahren und/oder Gießverfahren mit dem Grundkörper verbunden wird. Dies ermöglicht ein gleichzeitiges Verbinden des Solarmoduls und der Deckschicht mit dem Grundkörper in einem Verfahrensschritt, wodurch erhebliche Zeit- und Kostenvorteile erzielt werden. Auch die weitere Formhälfte kann dabei in Abhängigkeit der gewünschten Geometrie des Grundkörpers eben oder gewölbt ausgebildet sein.

Dabei hat es sich insbesondere beim Herstellen gewölbter Verkleidungsteile als vorteilhaft gezeigt, dass die Deckschicht vor dem Anordnen in der weiteren Formhälfte mittels eines Thermoformverfahrens umgeformt wird. Die Deckschicht besitzt somit bereits vor dem Verbinden mit dem Grundkörper die erwünschte Geometrie, wodurch das Entstehen optisch unerwünschter Oberflächenunregelmäßigkeiten besonders zuverlässig vermieden wird. Dabei kann vorgesehen sein, dass die Aussparung vor- oder nach dem Thermoformverfahren durch ein Trennverfahren in die Deckschicht eingebracht wird.

Weitere Vorteile ergeben sich dadurch, dass im Bereich der Aussparung zusätzlich eine transparente Kunststoffschicht an die Deckschicht angeformt wird. Dies ermöglicht einen verbesserten Schutz der Oberfläche des Grundkörpers im Bereich der Aussparung gegen Verkratzen, erhöhte UV-Belastung und dergleichen.

Eine weitere vorteilhafte Möglichkeit zum Einbringen der Aussparung in die Deckschicht ist dadurch gegeben, dass die Deckschicht derart auf den Grundkörper aufgeklebt wird, dass die Deckschicht die dem zumindest einen Solarmodul zugeordnete Aussparung aufweist. Auf diese Weise ist es nicht erforderlich, die Aussparung in einem zusätzlichen Arbeitsschritt in die Deckschicht einbringen zu müssen.

Dabei hat es sich in weiterer Ausgestaltung als vorteilhaft gezeigt, dass als Kunststoff ein Poly(methyl)methacrylat und/oder ein Polycarbonat und/oder ein Cyclo-Olefin-Copolymer und/oder ein Flüssigkristall-Polymer verwendet wird. Polymethylmethacrylat (PMMA) stellt dabei einen splitterfreien und leichten Ersatzstoff für Glas dar. Polycarbonate bieten den Vorteil, dass sie einerseits sehr dimensionsstabil sowie einfach schweiß- und klebbar sind und außerdem eine hohe Schlagzähigkeit besitzen. Cyclo-Olefin-Copolymere weisen eine hohe Wärmeformbeständigkeit auf und können durch Variierung der Edukte optimal an den jeweiligen Einsatzzweck des Grundkörpers angepasst werden. Flüssigkristall-Polymere besitzen ihrerseits hervorragende mechanische und chemische Eigenschaften und weisen neben einer hohen Zugfestigkeit auch eine hohe Widerstandskraft gegenüber Umwelteinflüssen auf.

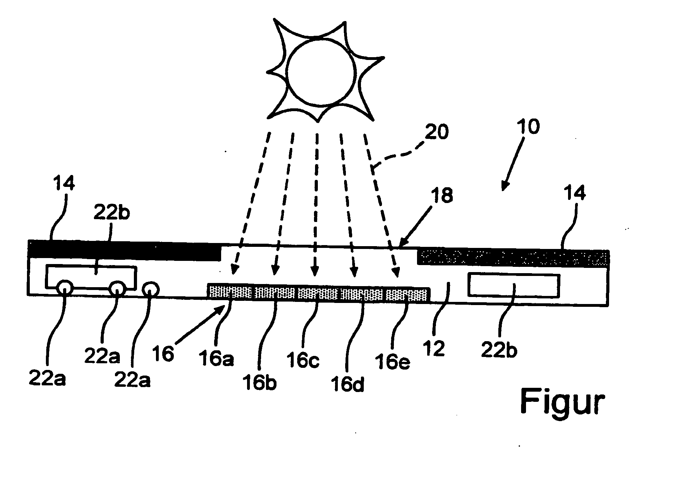

Weitere Vorteile, Merkmale und Einzelheiten der Erfindung ergeben sich aus der nachfolgenden Beschreibung eines Ausführungsbeispiels sowie anhand der Zeichnung. Dabei zeigt die einzige Figur eine schematische seitliche Schnittdarstellung eines Verkleidungsteils gemäß einem Ausführungsbeispiel.

Die einzige Figur, in welcher gleiche oder funktionsgleiche Elemente mit identischen Bezugszeichen versehen sind, zeigt eine schematische seitliche Schnittdarstellung eines Verkleidungsteils für ein Kraftfahrzeug gemäß einem Ausführungsbeispiel. Das Verkleidungsteil, welches im gezeigten Ausführungsbeispiel als Schiebe- oder Lichtdach für ein Hybridfahrzeug (nicht gezeigt) ausgebildet ist, umfasst dabei einen Grundkörper 10, welcher im vorliegenden Beispiel vollständig aus einem lichtdurchlässigen Kunststoff 12 besteht und dessen Außenseite durch eine Deckschicht 14 überdeckt ist. Als Kunststoff 12 wird dabei Polymethylmethacrylat verwendet, welches einen splitterfreien und leichten Ersatzstoff für Glas darstellt. Alternativ können auch andere geeignete Kunststoffe wie Polycarbonate, Cyclo-Olefin-Copolymere oder Flüssigkristall-Polymere eingesetzt werden. Weiterhin trägt der Grundkörper 10 ein Solarmodul 16, welches eine Mehrzahl an miteinander verbundenen und aus dem Stand der Technik bekannten Solarzellen 16a-e umfasst. Das gezeigte Solarmodul 16 ermöglicht dabei eine Leistungsabgabe von bis zu 300W und kann vorteilhaft mit einer Energiespeichereinheit eines Elektromotors des Hybridantriebs gekoppelt werden. Die Deckschicht 14, welche vorliegend als in Kraftfahrzeugfarbe eingefärbte und lichtundurchlässige Außenlackfolie ausgebildet ist, weist dabei im Anordnungsbereich des Solarmoduls 16 eine diesem zugeordnete Aussparung 18 auf, welche den Eintritt von Licht 20 durch den Kunststoff 12 auf das Solarmodul 16 ermöglicht. Der Grundkörper 10 weist zudem mehrere Verstärkungselemente 22 auf, welche sowohl metallische Strukturträger 22a als auch Faserverstärkungen 22b umfassen. Die Verstärkungselemente 22 sind dabei unterhalb der Deckschicht 14 angeordnet und somit nicht von außen sichtbar. Dies gewährleistet einen vorteilhaften optischen Eindruck des Verkleidungsteils, welches sich nach dem Einbau harmonisch in eine Karosserie einfügen kann.

Das gezeigte Verkleidungsteil wird hergestellt, indem die mit der Aussparung 18 versehene Deckschicht 14 in eine die Außenkontur des Grundkörpers 10 repräsentierende Formhälfte einer Spritzgussvorrichtung gebracht wird. Zuvor kann die Deckschicht 14 gegebenenfalls mittels eines Thermoumformverfahrens in eine gewünschte dreidimensionale Form umgeformt werden. Dies bietet sich insbesondere dann an, wenn der Grundkörper 10 eine gewölbte Außenkontur aufweisen soll. Das Solarmodul 16 wird in die weitere Formhälfte der Spritzgussvorrichtung eingelegt, wobei auf eine korrekte Ausrichtung hinsichtlich der in der ersten Formhälfte angeordneten Aussparung 18 zu achten ist. Dabei kann das Solarmodul 16 wahlweise auf der Formhälfte aufliegen oder mittels eines Abstandhalters mit einem vorgebbaren Abstand zur Formhälfte angeordnet werden. Die Verstärkungselemente 22 können ebenfalls in einer der beiden Formhälften angeordnet werden. Alternativ können auch entsprechende Aussparungen vorgesehen werden, in welche die Versteifungselemente 22 nachträglich eingelegt oder eingeklebt werden. Anschließend werden die beiden Formhälften geschlossen und der Kunststoff 12 eingespritzt, wodurch der Grundkörper 10 gebildet und sowohl mit der Deckschicht 14 als auch mit dem Solarmodul 16 verbunden wird. Alternativ kann auch vorgesehen sein, dass das Solarmodul 16 mit dem transparenten Kunststoff 12 überdeckt und mit einem weiteren, nicht notwendigerweise transparenten Kunststoff hinterspritzt wird. Das Spritzgussverfahren ermöglicht dabei gegenüber beispielsweise einem Laminierverfahren eine signifikante Senkung der Produktionszeit- und der Produktionskosten. Anstelle des Spritzgussverfahrens kann jedoch auch ein Spritzpräge- oder ein Gießverfahren verwendet werden, welche die gleichen Vorteile ermöglichen. Alternativ kann auch zunächst der Grundkörper 10 mit dem Solarmodul 16 und gegebenenfalls den Verstärkungselementen 22 hergestellt und die Deckschicht 14 anschließend aufgeklebt werden.

## Patentansprüche

1. Verkleidungsteil der Außen- oder Innenverkleidung von Kraftfahrzeugen mit einem Grundkörper (10), welcher zumindest teilweise aus einem lichtdurchlässigen, wenigstens ein Solarmodul (16) tragenden Kunststoff (12) besteht und der Kunststoff das Solarmodul (16) zumindest auf der sonnenzugewandten Seite oder Außenseite des Verkleidungsteils vollständig formschlüssig umgibt **dadurch gekennzeichnet, dass** dessen sonnenzugewandte Seite oder Außenseite zumindest bereichsweise durch eine lichtundurchlässige und gefärbte Deckschicht (14) überdeckt ist, die zumindest im Anordnungsbereich des Solarmoduls (16) eine diesem zugeordnete Aussparung (18) aufweist und die Aussparung (18) durch eine UV-Schutzschicht und/oder eine Kratzschutzschicht abgedeckt ist.

2. Verkleidungsteil nach Anspruch 1,
**dadurch gekennzeichnet, dass**
das Solarmodul (16) in den Kunststoff (12) eingegossen ist.

3. Verkleidungsteil nach einem der voran gegangenen Ansprüche,
**dadurch gekennzeichnet, dass**
dessen Außenseite die Oberfläche eines selbsttragenden Verkleidungsteils,Beplankungsteils, Dachs, Schiebedachs, Verscheibung, Frontklappe oder Heckklappe ausbildet.

4. Verkleidungsteil nach Anspruch 3,
**dadurch gekennzeichnet, dass**
die Deckschicht (14) als Lackschicht oder als Außenlackfolie oder als Glasschicht ausgebildet ist.

5. Verkleidungsteil nach Anspruch 1 oder 2,
**dadurch gekennzeichnet, dass**
dessen sonnenzugewandte Seite die Oberfläche einer Innenverkleidung eines Kraftfahrzeugs, insbesondere Instrumententräger oder Hutablage bildet.

6. Verkleidungsteil nach Anspruch 5,
**dadurch gekennzeichnet, dass**
die Deckschicht (14) als Kunststofffolie ausgebildet ist.

7. Verkleidungsteil nach einem der voran gegangenen Ansprüche ,
**dadurch gekennzeichnet, dass**
der Grundkörper (10) zusätzlich wenigstens ein Versteifungselement (22), insbesondere einen zumindest teilweise eingegossenen Strukturträger (22a) und/oder eine Faserverstärkung (22b) umfasst.

8. Verkleidungsteil nach einem der voran gegangenen Ansprüche,
**dadurch gekennzeichnet, dass**
das Solarmodul (16) des Verkleidungsteils mit einem Energiespeicherelement, insbesondere einer Batterie eines Elektroantriebs, eines Kraftfahrzeugs koppelbar ist und ausgelegt ist, das Energiespeicherelement mit elektrischer Energie zu versorgen.

9. Verfahren zum Herstellen eines Verkleidungsteils für ein Kraftfahrzeug, durch Verbinden wenigstens eines Solarmoduls (16) mit einem zumindest teilweise aus einem lichtdurchlässigen Kunststoff (12) bestehenden Grundkörper (10) des Verkleidungsteils,
**dadurch gekennzeichnet, dass**,
das Solarmodul (16) in den Kunststoff eingegossen wird, so dass zumindest die sonnenzugewandte Seite oder Außenseite des Verkleidungsteils vollständig eingegossen ist, wobei beim Eingießen des Solarmoduls (16) zugleich eine lichtundurchlässige und gefärbte Deckschicht (14) an der sonnenzugewandten Seite angegossen wird, die zumindest eine dem Solarmodul (16) zugeordnete Aussparung (18) aufweist,
und dass im Bereich der Aussparung (18) zusätzlich eine transparente Kunststoffschicht als UV-Schutzschicht und/oder Kratzschutzschicht an die Deckschicht (14) angeformt wird.

10. Verfahren nach Anspruch 9,
**dadurch gekennzeichnet, dass**
zum Eingießen des wenigstens einen Solarmoduls (16) in den Grundkörper (10) das wenigstens eine Solarmodul (16), gegebenenfalls mittels eines Abstandhalters, innerhalb einer Formhälfte einer Formvorrichtung angeordnet und der Grundkörper (10) mittels eines Spritzgussverfahrens und/oder eines Spritzprägeverfahrens und/oder eines Gießverfahrens aus dem Kunststoff (12) hergestellt wird.

11. Verfahren nach Anspruch 9 oder 10,
**dadurch gekennzeichnet, dass**
zum Verbinden des Grundkörpers (10) mit der Deckschicht (14) zunächst die an eine Außenoberfläche des Verkleidungsteils angepasste Deckschicht (14), in welche die dem zumindest einen Solarmodul (16) zugeordnete Aussparung (18) eingebracht wird, in einer an eine Außenkontur des Verkleidungsteils angepassten weiteren Formhälfte der Formvorrichtung angeordnet und durch das Spritzgussverfahren und/oder Spritzprägeverfahren und/oder Gießverfahren mit dem Grundkörper (10) verbunden wird.

12. Verfahren nach Anspruch 11,
**dadurch gekennzeichnet, dass**
die Deckschicht (14) vor dem Anordnen in der weiteren Formhälfte mittels eines Thermoformverfahrens umgeformt wird.

13. Verfahren nach einem der Ansprüche 9 bis 12,
**dadurch gekennzeichnet, dass**
als Kunststoff (12) ein Polymethylmethacrylat und/oder ein Polycarbonat und/oder ein Cyclo-Olefin-Copolymer und/oder ein Flüssigkristall-Polymer verwendet wird.

## Claims

1. Panel part of the exterior or interior panelling of motor vehicles, comprising a base body (10) which consists at least partially of a transparent plastic material (12) supporting at least one solar module (16), the plastic material surrounding the solar module (16) completely positively at least on the sun-facing side or outside of the panel part, **characterised in that** at least sections of its sun-facing side or outside are covered by an opaque and coloured cover layer (14) which has a cut-out (18) assigned to the solar module (16) at least in the location region of the latter, and **in that** the cut-out (18) is covered by an UV protection layer and/or by a protective layer against scratches.

2. Panel part according to claim 1,
**characterised in that**
the solar module (16) is cast into the plastic material (12).

3. Panel part according to any of the preceding claims,
**characterised in that**
its outside forms the surface of a self-supporting panel part, cladding part, roof, sun roof, glazing part, engine cover or tailgate.

4. Panel part according to claim 3,
**characterised in that**
the cover layer (14) is a paint layer, an outside paint film or a glass layer.

5. Panel part according to claim 1 or 2,
**characterised in that**
the sun-facing side forms the surface of an interior panelling of a motor vehicle, in particular an instrument panel or a rear shelf.

6. Panel part according to claim 5,
**characterised in that**
the cover layer (14) is designed as a plastic film.

7. Panel part according to any of the preceding claims,
**characterised in that**
the base body (10) additionally comprises at least one reinforcing element, in particular an at least partially cast-in structural member (22a) and/or a fibre reinforcement (22b).

8. Panel part according to any of the preceding claims,
**characterised in that**
the solar module (16) of the panel part can be coupled to an energy storage element, in particular to a battery of an electric drive, of the motor vehicle and is designed to supply the energy storage element with electric energy.

9. Method for producing a panel part for a motor vehicle by joining at least one solar module (16) to a base body (10) of the panel part which consists at least partially of a transparent plastic material (12),
**characterised in that**
the solar module (16) is cast into the plastic material, so that at least the sun-facing side or outside of the panel part is completely cast in, wherein, simultaneous with the casting-in of the solar module (16), an opaque and coloured cover layer (14) is applied on the sun-facing side, the cover layer (14) having at least one cut-out (18) assigned to the solar module (16),
and **in that** a transparent plastic layer is formed on the cover layer (14) in the region of the cut-out (18) to serve as an UV protection layer and/or a protective layer against scratches.

10. Method according to claim 9,
**characterised in that**
for casting the at least one solar module (16) into the base body (10), the at least one solar module (16) is, possibly by means of a spacer, placed within a mould half of a moulding device, and the base body (10) is produced from the plastic material (12) by means of an injection moulding process and/or an injection compression moulding process and/or a casting process.

11. Method according to claim 9 or 10,
**characterised in that**
to join the base body (10) to the cover layer (14), the cover layer (14) matched to an outer surface of the panel part, in which cover layer (14) the cut-out (18) assigned to the at least one solar module (16) is produced, is first placed within a further mould half of the moulding device and then joined to the base body (10) using the injection moulding process and/or the injection compression moulding process and/or the casting process.

12. Method according to claim 11,
**characterised in that**
the cover layer (14) is formed in a thermoforming process before being placed within the further mould half.

13. Method according to any of claims 9 to 12,
**characterised in that**
a polymethyl acrylate and/or a polycarbonate and/or a cyclo-olefin copolymer and/or a liquid crystal polymer is used as a plastic material (12).

## Revendications

1. Élément de l'habillage extérieur ou intérieur de véhicules à moteur comprenant un corps de base (10) constitué au moins en partie d'une matière plastique (12) transparente portant au moins un module (16) solaire et la matière plastique entourant complètement le module (16) solaire par complémentarité de forme au moins sur le côté tourné vers le soleil ou sur le côté extérieur de l'élément d'habillage, **caractérisé en ce que** ce côté exposé au soleil ou le côté extérieur est recouvert, au moins par endroits, d'une couche de recouvrement (14) essentiellement opaque et/ou colorée, qui comprend au moins un évidement (18) associé au module solaire, l'évidement étant situé dans la zone d'agencement du module solaire (16) et l'évidement (18) étant recouvert par une couche de protection contre les UV et/ou une couche de protection contre les rayures.

2. Élément d'habillage selon la revendication 1, **caractérisé en ce que** le module solaire (16) est moulé dans la matière plastique (12).

3. Élément d'habillage selon l'une quelconque des revendications précédentes, **caractérisé en ce que** ce côté extérieur forme la surface d'un élément d'habillage autonome, d'un élément de revêtement, d'un toit, d'un toit ouvrant, d'une vitre, d'un capot ou d'un hayon.

4. Élément d'habillage selon la revendication 3, **caractérisé en ce que** la couche de recouvrement est conçue comme une couche de peinture ou en tant qu'un film de peinture extérieur ou encore en tant que couche de verre.

5. Élément d'habillage selon la revendication 1 ou la revendication 2, **caractérisé en ce que** ce côté exposé au soleil forme la surface d'un habillage intérieur d'un véhicule à moteur, en particulier un support d'instrument ou une plage arrière.

6. Élément d'habillage selon la revendication 5, **caractérisé en ce que** la couche de recouvrement (14) est conçue comme un film en matière plastique.

7. Élément d'habillage selon l'une quelconque des revendications, **caractérisé en ce que** le corps de base (10) comprend en plus au moins un élément de renfort (22), en particulier une poutre structurelle (22a) au moins partiellement moulée et/ou un renfort de fibres (22b).

8. Élément d'habillage selon l'une quelconque des revendications, **caractérisé en ce que** le module (16) solaire de l'élément d'habillage peut être couplé à un élément accumulateur d'énergie, en particulier à une batterie d'un moteur électrique, d'un véhicule à moteur et conçu pour alimenter l'élément accumulateur d'énergie en énergie électrique.

9. Procédé de fabrication d'un élément d'habillage destiné à un véhicule à moteur, en reliant au moins un module (16) solaire à un corps de base (10) de l'élément d'habillage constitué au moins partiellement d'une matière plastique (12) transparente, **caractérisé en ce que** le module (16) solaire est moulé dans la matière plastique, de telle manière qu'au moins le côté exposé au soleil ou le côté extérieur de l'élément d'habillage est complètement moulé, au moment du moulage du module (16) solaire, une couche (14) de recouvrement colorée et opaque est moulée sur le côté exposé au soleil, l'au moins un module (16) solaire présentant un évidement (18) associé, et **en ce que** dans la région de l'évidement (18) une couche de matière plastique transparente est également formée en tant que couche de protection contre les UV et/ou couche de protection contre les rayures sur la couche de recouvrement (14).

10. Procédé selon la revendication 9, **caractérisé en ce que** pour mouler l'au moins un module (16) solaire dans le corps de base (10) l'au au moins un module (16) solaire, si nécessaire au moyen d'un support d'écartement, est disposé dans une moitié de moule d'un dispositif de moulage et le corps de base (10) est fabriqué par un procédé de moulage par injection et/ou par un procédé d'estampage par injection et/ou un procédé de moulage dans la matière plastique (12).

11. Procédé selon la revendication 9 ou la revendication 10, **caractérisé en ce que** pour relier le corps de base (10) à la couche de recouvrement (14) la couche de recouvrement (14) adaptée à une surface extérieure de l'élément d'habillage, dans laquelle l'évidement (18) associé à l'au moins un modèle (16) solaire est introduit, est d'abord disposée dans une autre moitié de moule du dispositif de moulage adaptée à un contour extérieur de l'élément d'habillage et reliée par un procédé de moulage par injection ou par un procédé d'estampage par injection et/ou par un procédé de moulage au corps de base (10).

12. Procédé selon la revendication 11, **caractérisé en ce que** la couche de recouvrement (14) est mise en forme avant qu'elle ne soit disposée dans les autres moitiés de moule au moyen d'un procédé de thermo-moulage.

13. Procédé selon l'une quelconque des revendications 9 à 12, **caractérisé en ce que** la matière plastique (12) utilisée est un polyméthacrylate de méthyle et ou polycarbonate et/ou un copolymère oléfine cyclique et/ou un polymère à cristaux liquides.
